# EUROPEAN PATENT SPECIFICATION

(11) **EP 2 847 600 B1**
(45) Date of publication and mention of the grant of the patent: **23.01.2019**
(21) Application number: 13728784.3
(22) Date of filing: 09.05.2013
(51) Int. Cl.: G01R 27/14, G08B 29/06, G08B 29/08, G08B 29/12, G01R 31/02

(54) **AN APPARATUS AND ASSOCIATED METHOD FOR MEASURING A SERIES RESISTANCE**
VORRICHTUNG UND ZUGEHÖRIGES VERFAHREN ZUR MESSUNG EINES SERIENWIDERSTANDS
APPAREIL ET PROCÉDÉ ASSOCIÉ POUR MESURER UNE RÉSISTANCE SÉRIE

(30) Priority: 11.05.2012 GB 201208289
(43) Date of publication of application: 18.03.2015
(73) Proprietor: Computionics Limited, Wigan, Lancashire WN8 7AS (GB)
(72) Inventor: ANDREW, Foster, Wigan Lancashire WN8 7AS (GB)
(74) Representative: Wilson Gunn
(86) International application number: PCT/GB2013/051203
(87) International publication number: WO 2013/167899

(56) References cited:
- EP-A2- 2 105 898
- DE-A1-102008 003 799
- DE-A1-102010 003 353
- US-A1- 2005 270 042
- US-A1- 2009 206 854
- US-A1- 2009 212 937
- US-B1- 6 356 086
- T.C. Murphy, R.B. Wright: "Evaluation of Saft America, Inc. Electochemical Capacitors", , December 1997 (1997-12), pages FP-A-41, XP002713126, US Retrieved from the Internet: URL:http://www.osti.gov/bridge/servlets/pu rl/573327-89mI2X/webviewable/573327.pdf [retrieved on 2013-09-16]

## Description

### Technical Field Of The Invention

The present invention relates to an apparatus and associated method for measuring an unknown resistance which is in series with another, typically larger, load impedance. Particularly, but not exclusively, it relates to an apparatus and associated method for determining the series resistance of a fire alarm circuit.

### Background To The Invention

The operation of single circuit monitoring for open and short circuit fault detection of a single circuit is well known. A power supply with an internal impedance is used to power a circuit and the output voltage of said power supply is monitored. If there is a short circuit fault, the output voltage will tend to zero whereas for an open circuit fault, the output voltage will tend towards the maximum voltage of the power supply.

For example, a known type of fire alarm circuit comprises a Fire Alarm Control and Indicating Equipment (FACIE) unit, which comprises a battery. The FACIE typically has a high internal resistance and therefore an output voltage which is dependent upon the load which is attached to the FACIE. The output voltage is monitored and various states of the fire alarm system correspond to different ranges of said output voltage. In particular, when the voltage is below a first voltage threshold a short circuit fault is detected and when the voltage is above a second voltage threshold an open circuit fault is detected. When the voltage is between the first and second thresholds, no fault is determined. This monitoring method is particularly convenient since it allows the status of the circuit to be monitored whilst still supplying sufficient power for its normal operation.

The load connected to the FACIE typically comprises a circuit with a plurality of parallel branches. Each branch may comprise a current demanding fire alarm device such as a smoke detector and/or a fire alarm sounder. The farthest branch from the FACIE comprises an end of line (EOL) element, usually consisting of a resistor or capacitor, across which the output voltage is developed under normal conditions. When a fire is detected, one or more current demanding fire alarm devices draw a current and the output voltage of the FACIE will drop below a third threshold voltage, indicating that there is a fire.

Typically such circuits may comprise total lengths of cable from 1 to >1000 metres. As the circuit becomes longer there is a greater chance that faults may occur. Certain effects in such circuits such as finite cable resistance and cable joint faults can result in a series resistance in either or both legs of the circuit and there will be a corresponding voltage drop across this series resistance. This voltage drop will alter the potential difference across each of the branches of the circuit, with those branches farther away from the FACIE being more severely affected. If the series resistance is sufficiently large it may result in the voltage across one or more current demanding devices falling outside of its voltage compliance range. As a result the current demanding device (for example a smoke detector or a fire alarm sounder) may not operate properly, if at all. Therefore there is a need for a means of measuring the series resistance and, if it is sufficiently high to cause the voltage across one or more current demanding devices to fall outside of its voltage compliance range, signalling this to the FACIE.

These effects will be especially significant for those current demanding devices which are farthest away from the FACIE and in situations where a multiplicity of devices that demand higher amounts of current when in operation (for example fire alarm sounders) are connected to the circuit. In such situations a total series resistance of the order of <50Ω, and in some cases <10Ω, can cause malfunction of current demanding devices connected to the circuit, especially where total operating currents of 1A or greater are concerned.

However, series resistances at this level will not give rise to an output voltage which exceeds the second threshold and therefore the FACIE will not register a fault. In fact, the change in output voltage of the FACIE will be proportional to the ratio of the series resistance to the sum of the series resistance, the internal impedance of the FACIE and the EOL resistance. Since the internal impedance of the FACIE and the EOL resistance are typically each of the order of >1kΩ, several orders of magnitude greater than the level of series resistance that may cause malfunction of current demanding devices connected to the circuit, this change in output voltage is small. Therefore, in order to determine the series resistance from the output voltage of the FACIE one would require a resolution of the order of 1 part in 1000.

A further complication arises due to the intrinsic reactance (both capacitive and inductive) of the circuit which has a tendency to cause 'ringing' on the circuit when measured at any point on the circuit. This can have a considerable effect on the dynamic stability of any devices connected to the circuit and the measurement of any parameters of interest. Furthermore, this effect becomes more pronounced as the length of the circuit increases and can become significant.

The aforementioned monitoring methods are either not capable of detecting such series resistance faults or are not capable of detecting such faults to a sufficiently high degree of accuracy, or low enough impedance level, especially when reactive effects are required to be taken into consideration.

It is an object of embodiments of the present invention to at least partially address these problems.

Some examples of prior art can be seen in US 2005/270042 A1, US 6 356 086 B1, and DE 10 2010 003353 A1.

### Summary Of The invention

According to a first aspect of the present invention there is provided a method of measuring an unknown resistance in a circuit, as claimed in claim 1.

Advantageously, such a method allows for a resistance that is significantly smaller than the impedance of the load to be measured accurately. Also, by extrapolating to determine the potential difference across the load it is possible to exclude, or at least minimise, the effect of any intrinsic reactance to the circuit and to determine the series resistance without knowing the capacity of the capacitor.

The capacitor may be fully or partially charged, and allowed to discharge to drive the forced current. Alternatively the capacitor could be charged by the forced current.

The capacitor may be connected in parallel to output terminals of a D.C. power supply. The power supply may include an output impedance. The capacitor may have a serial resistance which is lower than the output impedance of the power supply. The serial resistance of the capacitor could be less than 1/100^{th} or 1/1000^{th} of the impedance of the power supply. Thus, the current which is forced through the circuit is substantially derived from the capacitor. The power supply may comprise two output terminals. Each output terminal may be connected to a different end of the circuit. The power supply may comprise a D.C. voltage source, such as a battery, and an internal impedance. The internal impedance may comprise an internal resistance in series with the voltage source.

The time constant of the capacitor and the time between the two measurements of potential difference made whilst a current is forced through the circuit may be chosen so that the fractional reduction in potential difference across the capacitor between the two measurements is small say less than 30%, 20% or 10%.

The first mentioned step of measuring the potential difference across the load may take place before the step of forcing a current through the circuit, or it could take place after current has been forced through the circuit and the capacitor subsequently recharged.

The known current may be substantially constant, at least between the times at which potential difference across the load is measured during forcing of the current. Indeed, the forced current may be gradually increased from zero to a known, substantially constant, value. In this case the rate of increase of the current may be chosen to critically damp or over damp the effects of intrinsic reactance of the circuit on the potential difference across the load.

The time constant of the capacitor may be significantly larger than that of the intrinsic reactance of the circuit. Advantageously, this means that once the effects of the intrinsic reactance of the circuit on potential difference across the load have decayed away, the variation in potential difference across the load is due to the reactance of the capacitor. In the case of a capacitor of much lower serial resistance than any power supply connected in parallel to the capacitor, once any effects from the intrinsic reactance of the circuit have stabilised, the potential difference will fall linearly with time due to the discharge of the capacitor by the substantially constant current.

The circuit may be permanently connected to the capacitor, in parallel with a D.C. power supply which keeps the capacitor charged. When a current is forced in the circuit, the current may be significantly larger than a normal current flowing in the circuit, for example at least twice, or at least five times, that current, and the serial resistance of the capacitor may be chosen to be sufficiently lower than the output impedance of the power supply such that the forced current causes the capacitor to discharge. The method may involve a step of temporarily increasing the impedance of the load or of temporally disconnecting the load to enable the capacitor to be fully charged by the power supply.

The circuit may comprise a fire alarm circuit. The load may comprise an End Of Line (EOL) load for said fire alarm circuit. The power supply may comprise a Fire Alarm Control and Indicating Equipment (FACIE) for said fire alarm circuit.

The potential difference across the load may be monitored continuously, substantially continuously or at a finite number of discrete times.

Current may be forced through the circuit by reducing the impedance of the load. Or, current could be forced through the circuit by bypassing the load. Where the load is by-passed the load could be disconnected from the circuit whilst current is forced through the circuit. Where the load is bypassed or replaced, the combination of the load and the arrangement for forcing current, or the arrangement for forcing current becomes the load for the purposes of measuring the potential difference across the load as current flows.

The load may comprise two terminals. It may be the potential difference across these two terminals that is measured. The load may comprise an active device. Said active device may comprise an active device according to the second aspect of the present invention.

The impedance of the load may comprise a load resistance connected across its two terminals. The load resistance may be controlled by a first switch in series therewith.

The load may further comprise a current source. The current source may be connected across the two terminals of the load and in parallel with the load resistance. The current source may be controlled by a second switch in series therewith and the step of forcing a known current through the circuit may be achieved by closing said second switch. The current source may be operable to force a substantially constant current through the circuit. The current source may be operable to gradually increase the value of the current that is forced through the circuit from zero up to the substantially constant current. Advantageously, this can reduce the effects of the intrinsic reactance (both capacitive and inductive) of the circuit on the potential difference across the load. Preferably, the rate at which the value of the current forced through the circuit increases is chosen so as to critically damp or over damp the effects of the intrinsic reactance (both capacitive and inductive) of the circuit on the potential difference across the load.

The load may comprise an amplifier and the method may further comprise the step of amplifying the potential difference across the load that has been monitored.

The method may comprise the step of stopping the forcing of the constant current through the circuit. That is, the constant current may only be forced through the circuit temporarily. The method may be repeated a time intervals.

In the event that the determined unknown resistance exceeds a threshold resistance the method may further comprise the step of sending a signal indicative of this. This signal may be sent to a fire alarm control panel or power supply connected to the circuit. The signal may be sent by manipulating the output voltage of the power source. The signal may only be sent if the determined unknown resistance exceeds the threshold resistance on a plurality of successive measurements. The signal may be sent by not increasing the impedance of the load back to its nominal value and/or not stopping the forcing of a known current through the circuit. That is, this step is no longer temporary.

According to a second aspect of the present invention there is provided an active device suitable for acting as an end of line load for a fire alarm circuit, said active device comprising: two terminals to which a fire alarm circuit may be connected; a load impedance connected between the terminals; a means for monitoring the potential difference across the two terminals; a means for forcing a known current through a fire alarm circuit connected to the two terminals; and a processor, the device being arranged to measure the potential difference across the two terminals whilst a known current is being forced through a circuit connected to the terminals at two points in time and deriving from those measurements, by extrapolation, a potential difference across the terminals at an earlier time whilst a current was being forced across the terminals.

Advantageously, such a device allows a load impedance to be connected to a circuit whilst allowing an unknown series resistance in said circuit that is significantly smaller than said load impedance to be determined accurately when the circuit is connected to a charged capacitor, which could, for example, be provided in parallel with a high impedance power supply to the circuit.

The active device may comprise a means for controlling the load impedance. This may increase the resolution of the active device, allowing smaller series resistances to be measured.

The means for forcing a known current through a circuit to which the two terminals are connected may comprises a current source connected across the two terminals of the active device and in parallel with the load impedance.

The load impedance and means for forcing a known current may be implemented by the same component or components.

The means for forcing a known current through a circuit may be operable to gradually increase the value of the current that is forced through the circuit from zero up to the substantially constant current.

The active device may be further arranged to measure the potential difference between the terminals when no current is being forced between the terminals, and to calculate the difference between this potential difference and that derived by extrapolation.

The active device may be further arranged to calculate a series resistance in a fire alarm circuit connected to the device using the calculated difference in potential differences and the value of the known current.

The active device may be arranged to draw power from a circuit connected to the two terminals.

The means for monitoring the potential difference across the two terminals may be operable to monitor said potential difference continuously, substantially continuously or at a finite number of discrete times.

The active device may comprise an amplifier. Said amplifier may be operable to amplify the monitored potential difference across the two terminals. The amplifier may comprise an inverting amplifier.

The active device may comprise a power supply unit. Said power supply unit may comprise an internal power supply, such as a battery. Alternatively, said power supply unit may draw power from a circuit connected to the two terminals. That is, the power supply unit may be connected to the two terminals. Advantageously, such an arrangement eliminates the need to replace batteries periodically. Preferably, said connection comprises a means for preventing the power supply unit from feeding back into the circuit and influencing it whilst allowing the power supply unit to draw power from the circuit. This means may comprise a diode.

The active device may comprise a voltage reference generator which may be set to a reference voltage. Said reference voltage may be the voltage output by the power supply unit. Alternatively, the reference voltage may a set fraction of the voltage output by the power supply unit, for example 30%.

According to a third aspect of the present invention there is provided a fire alarm system comprising a fire alarm circuit comprising an active device according to the second aspect of the present invention.

Preferably, the active device forms an end of line component for the fire alarm circuit.

The fire alarm circuit may comprise a Fire Alarm Control and Indicating Equipment (FACIE) unit. The FACIE may comprise a DC voltage source, such as a battery, and an internal impedance. Preferably, the internal impedance is low relative to an unknown series resistance it is desired to measure. The internal impedance may comprise an internal resistance in series with the battery. Preferably, the internal resistance comprises a capacitor connected across two output terminals of the power supply. The capacitor preferably has a low effective serial resistance.

The output voltage of the FACIE may be monitored. Said output voltage may be indicative of the state of the fire alarm system. For example, the voltage may be indicative of whether or not: there is short circuit fault; there is an open circuit fault; there is a fire; or the status is normal.

In addition to the active device, the load connected to the FACIE may comprise one or more parallel branches. Each branch may comprise a current demanding fire alarm device such as a smoke detector and/or a fire alarm sounder.

### Detailed Description Of The Invention

In order that the invention can be more clearly understood embodiments thereof are now described further below, by way of example, with reference to the accompanying drawings, of which:
- Fig. 1: is a schematic circuit diagram for a typical prior art single circuit fire alarm system;
- Fig. 2: is a schematic circuit diagram for a fire alarm system according to the present invention;
- Fig. 3: shows the output voltage of the FACIE of the fire alarm system shown in Fig.2 as a function of time during a measurement of an unknown series resistance using a method according to the present invention;
- Fig. 4: shows the potential difference across the SRMD of the fire alarm system shown in Fig.2 as a function of time during a measurement of an unknown series resistance using a first variation of a method according to the present invention; and
- Fig. 5: shows the potential difference across the SRMD of the fire alarm system shown in Fig.2 as a function of time during a measurement of an unknown series resistance using a second variation of a method according to the present invention.

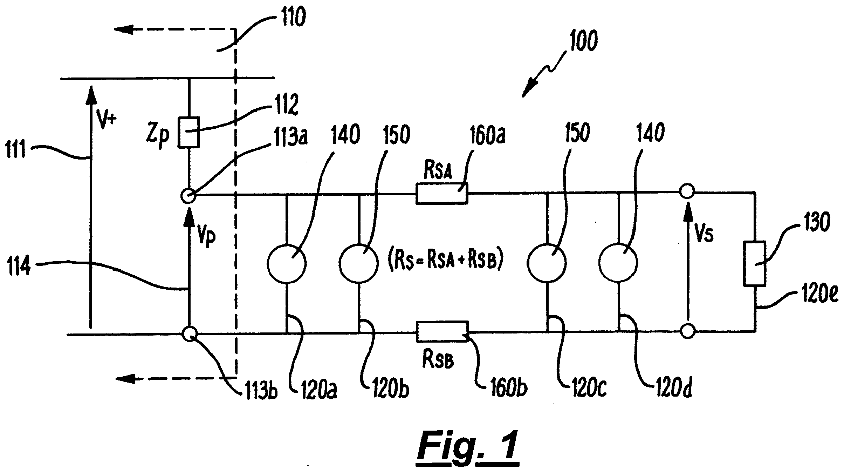

Referring to Fig. 1, a circuit diagram for a typical prior art single circuit fire alarm system 100 is shown. The fire alarm system 100 comprises a Fire Alarm Control and Indicating Equipment (FACIE) unit 110. The FACIE unit 110 comprises a battery and is operable to apply a potential difference 111 across an internal series impedance 112 and two output terminals 113a, 113b. The internal series impedance 112 is relatively high, typically of the order of >1kΩ or >5kΩ. Furthermore, the internal series impedance 112 is both non-linear and indeterminate.

The output voltage 114 of the FACIE is monitored and various states of the fire alarm system 100 correspond to different ranges of said output voltage 114. In particular, when the voltage 114 is below a first voltage threshold a short circuit fault is detected and when the voltage 114 is above a second voltage threshold an open circuit fault is detected. When the voltage 114 is between the first and second thresholds, no fault is determined. This monitoring method is particularly convenient since it allows the status of the circuit 100 to be monitored whilst still supplying sufficient power for its normal operation.

Across the two output terminals 113a, 113b of the FACIE is connected a load comprising a plurality of parallel branches 120a-120e. The farthest most branch 120e from the FACIE 110 comprises an end of line (EOL) element 130, which comprises a resistor. The resistance of the EOL element 130 is relatively high, typically of the order of >1kΩ. Each of the other branches 120a-120d comprises a current demanding fire alarm device such as a smoke detector 140 or a fire alarm sounder 150.

When a fire is detected, one or more current demanding fire alarm devices 140, 150 draws a current and the output voltage 114 of the FACIE 110 will drop below a third threshold voltage, indicating to the FACIE that there is a fire.

Typically such circuits 100 may comprise total lengths of cable from 1 to >1000 metres and as the circuit 100 becomes longer there is a greater chance that faults may occur. Certain effects in such circuits 100 such as finite cable resistance and cable joint faults result in a series resistance 160a, 160b in both legs of the circuit and there is a corresponding voltage drop across these series resistances 160a, 160b. This voltage drop will alter the potential difference across each of the branches 120a-120e of the circuit 100, with those branches farther away from the FACIE 110 being more severely affected. If the series resistance 160a, 160b is sufficiently large it may result in the voltage 114 across one or more current demanding devices 140, 150 falling outside of its voltage compliance range. As a result the current demanding device 160a, 160b may not operate properly, if at all.

Therefore there is a need for a means of measuring the total series resistance and, if it is sufficiently high to cause the voltage across one or more current demanding devices 140, 150 to fall outside of its voltage compliance range, signalling this to the FACIE 110.

These effects will be especially significant for those current demanding devices which are farthest away from the FACIE 110 and in situations where a multiplicity of devices that demand higher amounts of current when in operation, such as fire alarm sounders 150, are connected to the circuit. In such situations a total series resistance of the order of <50Ω, and in some cases <10Ω, can cause malfunction of current demanding devices connected to the circuit, especially where total operating currents of 1A or greater are concerned.

However, series resistances 160a, 160b at this level will not give rise to an output voltage 114 of the FACIE 110 which exceeds the second threshold and therefore the FACIE will not register a fault. In fact, the change in output voltage 114 of the FACIE 110 will be proportional to the ratio of the series resistance 160a, 160b to the sum of the series resistance 160a, 160b, the internal impedance 112 of the FACIE and the EOL 130 resistance. However, since the internal impedance 112 of the FACIE 110 and the EOL 130 resistance are each several orders of magnitude greater than the level of series resistance 160a, 160b that may cause malfunction of current demanding devices 140, 150, in order to determine the series resistance 160a, 160b from the output voltage 114 of the FACIE 110 one would require a resolution of the order of 1 part in 1000.

A further complication arises due to the intrinsic reactance (both capacitive and inductive) of the circuit 100 which has a tendency to cause 'ringing' on the circuit when measured at any point on the circuit. This can have a considerable effect on the dynamic stability of any devices connected to the circuit 100 and the measurement of any parameters of interest. Furthermore, this effect becomes more pronounced as the length of the circuit 100 increases.

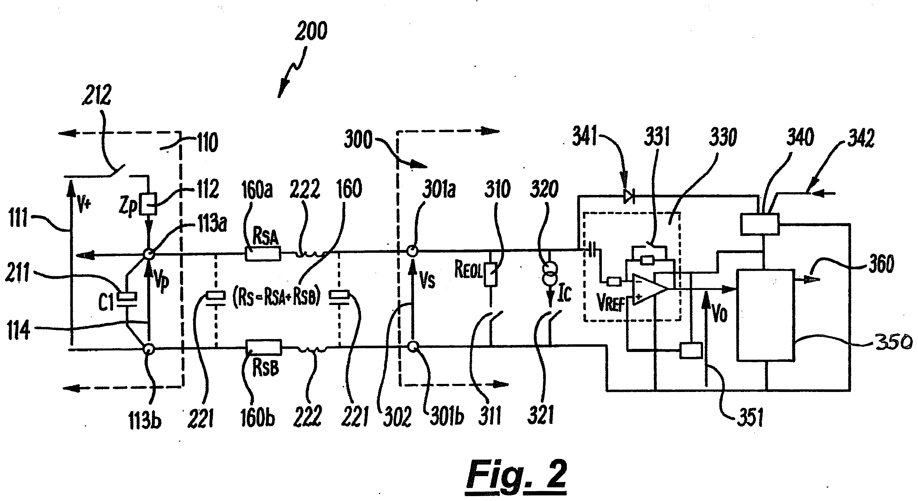

Referring to Fig. 2, a circuit diagram for a fire alarm system 200 according to the present invention is shown. For ease of comparison with Fig. 1, corresponding components have the same labels. Furthermore, only the differences between the two fire alarm systems 100, 200 will be described in detail below.

The output impedance of the FACIE 110 is instantaneously low in comparison with the series resistance 160 that it is desired to monitor. In order to achieve this, the FACIE unit 110 has been modified by the addition of a capacitor 211 across the two output terminals 113a, 113b. The capacitor 211 has a low effective serial resistance of <<1Ω and has a capacitance which reduces the output impedance of the FACIE 110 to a desirable level. Furthermore, the capacitor 211 has known impedance characteristics and has a time constant that is significantly greater than that of the intrinsic reactance of the circuit 200.

A power switch 212 controls the potential difference across the internal impedance 114 and the output terminals 113a, 113b of the FACIE 110.

For simplicity, one or more branches, each of which comprises a current demanding fire alarm device such as a smoke detector or a fire alarm sounder, are not shown in Fig. 2. As will be obvious to one skilled in the art any number of such current demanding fire alarm devices may be connected in parallel in the conventional manner as shown, for example, in Fig. 1.

The intrinsic reactance of the circuit 200 is shown schematically as effective cable capacitances 221 and effective cable inductances 222.

The EOL element 130 of Fig. 1 has been replaced with a Series Resistance Measurement Device (SRMD) 300 according to the present invention, which will now be described in further detail.

The SRMD 300 is an active device which provides an end of line resistance 310 for the fire alarm circuit 200 whilst allowing the unknown series resistance 160 in the circuit 200, which is significantly smaller than said end of line resistance 310 and the internal resistance 112 of the power supply, to be determined accurately. Furthermore, in the event that the series resistance 160 is found to be sufficiently high so as to cause the voltage across one or more current demanding devices 140, 150 to fall outside of its voltage compliance range the SRMD is operable to signal this to the FACIE 110.

The SRMD comprises two terminals 301a, 301b; a load impedance 310; and a means 320 for forcing a known current through a circuit to which the two terminals 301a, 301b are connected.

The load impedance 310 comprises a load resistance and is connected across the two terminals 301a, 301b. A first switch 311 is connected in series with the load resistance 310 and provides a means for controlling the load impedance 310.

The means 320 for forcing a known current through a circuit to which the two terminals. 301a, 301b are connected comprises a current source 320. The current source 320 is connected across the two terminals 301a, 301b of the SRMD 300 and is in parallel with the load resistance 310. A second switch 321 is connected in series with the current source 320 and provides a means for controlling the current that is forced through the circuit 200.

The current source 320 is operable to force a substantially constant current through the circuit 200 and is further operable to gradually increase the value of the current that is forced through the circuit 200 from zero up to the substantially constant current. Advantageously, this reduces the effects of the intrinsic reactance 221, 222 of the circuit 220 on the potential difference across the two terminals 301a, 301b when the current source 320 is switched on. The rate at which the value of the current forced through the circuit 200 increases is chosen so as to critically damp or over damp the effects of the intrinsic reactance 221, 222 of the circuit 200 on the potential difference across the two terminals 301a, 301b.

As will now be described, the SRMD 300 is operable to: monitor the potential difference 302 across the two terminals 301a, 301b; determine a drop in the potential difference 302 across the two terminals 301a, 301b; and combine the drop in potential difference 302 with the known current to determine an unknown series resistance.

The SRMD 300 comprises an inverting amplifier 330 with auto-zeroing, which is operable to amplify the potential difference 302 across the two terminals 301a, 301b. The amplifier 330 is provided with a switch 331 which will settle the output of the amplifier 330 to a reference voltage when closed, provided the current source 320 is not operating.

The SRMD 300 further comprises a power supply unit 340, which generates a stable operating voltage for the elements of the SRMD 300 from the two terminals 301a, 301b via a polarising diode 341. When the second switch 321 is open and the current source 320 is not forcing current, the power supply unit 340 may charge up from the circuit 200. The diode 341 prevents the power supply unit 340 from feeding back onto the circuit 200 wiring and influencing the signals on the lines when the current source 320 is forcing a current into the circuit 200. Alternatively, the power supply unit 340 may draw power from an external input source 342.

The SRMD 300 comprises a processing means 350, which is operable to control: the first switch 311, the second switch 321 and the switch 331 in the amplifier 330. The potential difference across the two terminals 301a, 301b is amplified so as to fall within a desired range and this modified voltage 351 is input into the processing means 350. The processing means 350 is further operable to analyse the modified voltage 351 so as to determine the unknown series resistance 160. To achieve this, the processing means 350 is programmed to implement a method of measuring an unknown resistance in a circuit according to the present invention, which will be described more fully below.

The SRMD 300 also comprises an external output and/or input 360, which is connected to the processing means 350.

The method periodically measures the unknown series resistance 160, with each measurement being completed during a first time period and the time inbetween measurements being a second time period. The first time period is significantly smaller than the second time period. For example, the first time period may be of the order of tens of microseconds or 1 millisecond and the second time period may be of the order of tens of seconds.

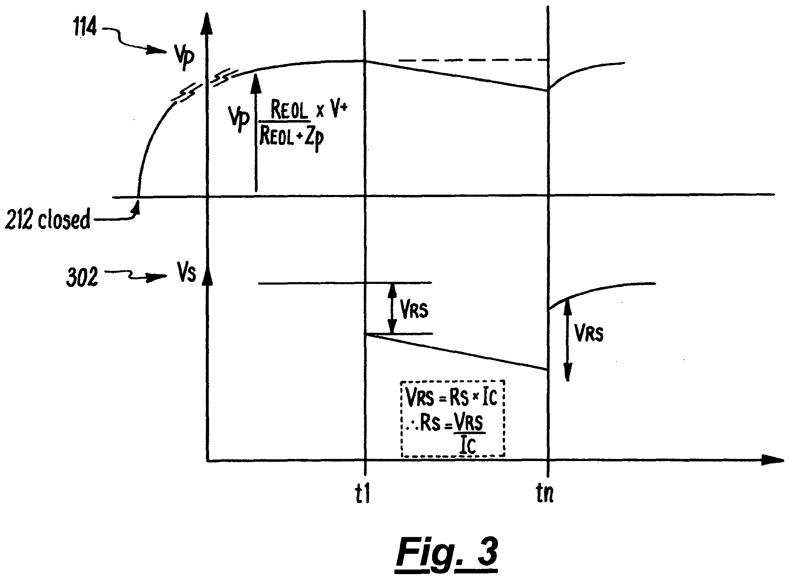

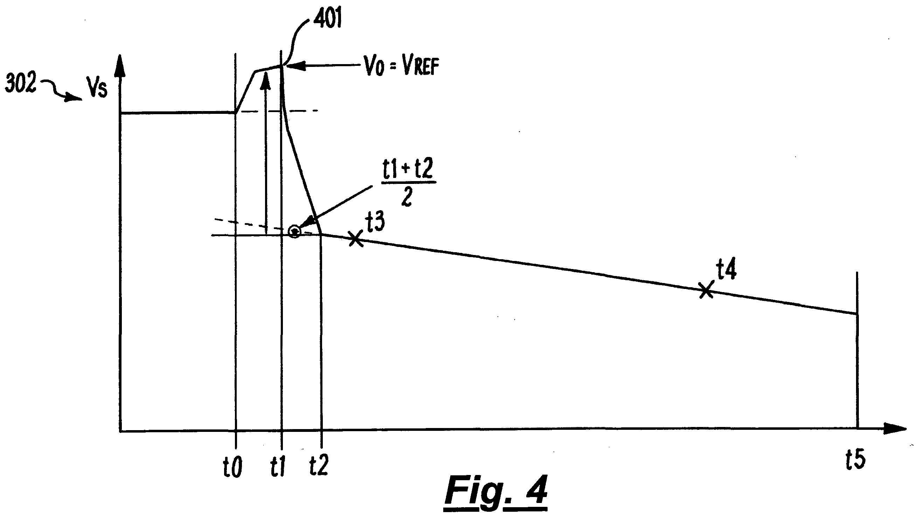

Referring to Figs. 3 & 4, the output voltage 114 of the FACIE 110 (Fig. 3) and the potential difference 302 across the SRMD 300 (Fig. 4) are shown as a function of time during a single measurement of the series resistance 160.

With reference to Fig. 4, at an initial time, t0, the switch 331 in the amplifier 330 is closed and the first switch 311 is opened. The voltage 302 tends towards a reference voltage 401 at t1. Initially, the voltage 302 rises steeply and, once the effects from the intrinsic reactance of the circuit 200 have stabilised the voltage 302 rises at a lower rate as the capacitor 211 continues to charge.

At t1, once the capacitor 211 has charged, the processing means 350 closes the second switch 321. The current source 320 forces a current through the circuit 200. The current source 320 steadily increases the current that is forced through the circuit 200 from zero up to the substantially constant current of, say, 20mA at t2. The rate at which the value of the current forced through the circuit 200 increases is chosen so as to critically damp or over damp the effects of the intrinsic reactance 221, 222 of the circuit 200 on the potential difference 302 across the two terminals 301a, 301b. Therefore, after t2 the voltage 302 decreases linearly with time as the capacitor 211 discharges under the constant current.

The processor 350 determines the potential difference 302 at two subsequent times, t3 and t4. Since the processor knows the time periods between t1 and t2, t2 and t3, and t3 and t4, the linear fall in potential difference 302 due to the capacitor discharging may be extrapolated back to a time between t1 and t2.

In principle, if the capacitance of the capacitor 211 were well known, the method would only need to determine the potential difference 302 at a single subsequent time, since the slope of the line is dependent upon said capacitance. However, in practice the value of the capacitance may not be known sufficiently accurately and may vary significantly depending on ambient conditions.

The processor next determines a drop in the potential difference 302 across the two terminals 301a, 301b, being the difference between the potential difference 302 as determined at t1 and the potential difference as measured at t3 and t4, extrapolated back to a time midway between t1 and t2.

The unknown series resistance 160 is determined to be the ratio of the drop in potential difference to the known constant current.

Finally, at tn, the first switch 311 is re-closed, the second switch 321 is re-opened and switch 331 in the amplifier 330 is re-opened. Normal operation of the circuit 200 resumes.

In the event that the determined unknown resistance 160 exceeds a threshold resistance on a plurality of successive measurements, the method further comprises the step of sending a signal to the FACIE unit 110 indicative of this. To achieve this, the SRMD 300 manipulates the output voltage 114 of the FACIE so that exceeds the second threshold and therefore shows a fault. This may be achieved by not re-closing the first switch 311 and/or re-opening the second switch 321.

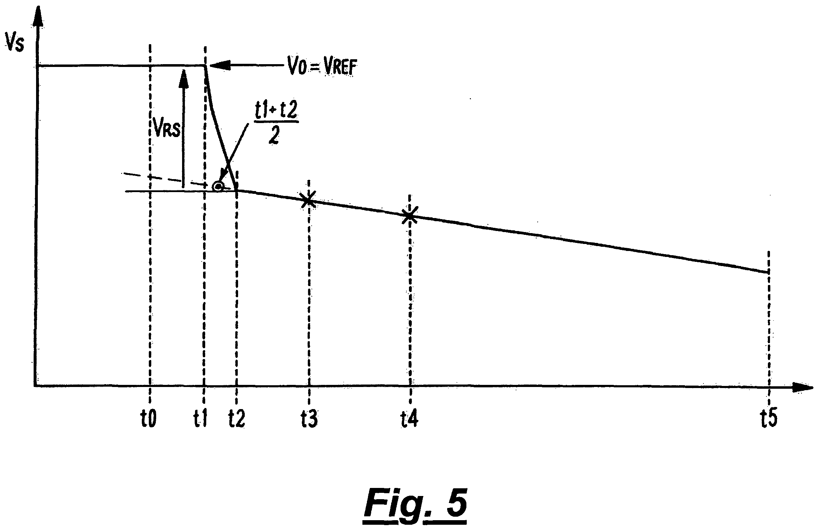

Referring to Fig. 5, the potential difference 302 across the SRMD 300 is shown as a function of time during a single measurement of the series resistance 160 using a second variant of the method described above. Only the differences between the two methods will be described in detail.

In this variant, the first switch 311 remains closed at the initial time, t0 Since the load resistor 310 remains connected to the circuit 200, the voltage 302 will remain at its initial steady value. By doing this, the requirement to wait until the effects from the intrinsic reactance of the circuit 200 and the capacitor 211 on the voltage 302 has stabilised is eliminated. For a typical fire alarm circuit the time required for these effects to stabilise may be significant, say of the order of tens of milliseconds. It can be undesirable to remove the load resistance, which is acting as an end of line resistance, from the circuit for such a long period of time since to do so may trigger an alarm or fault to the FACIE unit 110. Rather, the of time duration of a single measurement of the series resistance 160 should be of the order of tens or hundreds of microseconds.

The fact that the load resistor 310 remains connected to the circuit 200 will introduce an error into the measurement of the series resistance 160 due to the current which flows through the load resistor 310. However, this error can be controlled to an acceptable level by choosing the parameters of the apparatus appropriately. In particular, the current forced through the circuit 200 by the current source 320 is at least twice as large as the current that flows through the load resistor 310 before the current source is switched on. Furthermore, the capacitance of the capacitor 221 is chosen so that the fractional drop in potential across the capacitor 221 during the measurement process is small. For example, for a 22µF capacitor 221, the potential across the capacitor 221 may drop by less than 0.5V from an initial value of around 20 to 24V.

At t1, the processing means 350 closes the second switch 321, the current source 320 forces a current through the circuit 200 and the method proceeds as described above with reference to Fig. 4.

In this second variant of the method, typical timings may be as follows. The time period between t0 and t1 is around 50µs; the time period between t1 and t2 is around 5 to 10µs; the time period between t1 and t3 is around 100µs; and the time period between t3 and t4 is around 100µs.

The method according to the present invention essentially determines the difference in the voltage 302 across the SRMD 300 between: (a) when the known current is off; and (b) when the known current is on. In addition, the extrapolation removes, or at least limits, the effects of the reactance of the circuit 200 on this measurement. As will be understood by one skilled in the art, another way to achieve this is to reverse the order in which the measurements are made by first measuring the potential difference 302 across the SRMD 300 when the known current is on and, subsequently, when the known current is switched off, measuring the potential difference 302 across the SRMD 300 one or more times. An extrapolation of the potential difference measured at said one or more times may also be performed and would take into account the fact that the potential difference 302 across the SRMD 300 will change exponentially as the capacitor 221 charges or discharges.

It is of course to be understood that the invention is not to be restricted to the details of the above embodiment which has been described by way of example only. Many variations are possible within the scope of the following claims.

## Claims

1. A method of measuring an unknown resistance (160) in a circuit (200), said resistance (160) being connected in series with a load (300), the method comprising the steps of: connecting the circuit (200) to a capacitor (211), the capacitor (211) being connected in parallel to output terminals (113a, 113b) of a D. C. power supply (110) of unknown output impedance and the capacitor (211) has a serial resistance which is substantially lower than the output impedance of the power supply (110) and unknown serial resistance (160); measuring the potential difference (302) across the load (300); forcing a known constant current (320) through the circuit (200), wherein the forced current (320) is increased from zero to the substantially constant known current (320), and further comprising the steps of whilst forcing the known constant current (320), measuring the potential difference across the load (300) at two points in time, at which the forced known current (320) is substantially constant, and the potential differences (302) measured at the two points in time are used to derive, by extrapolation, the potential difference across the load (300) at an earlier point in time between the time when a current (320) begins to be forced across the load and the time when the forced known current (320) becomes substantially constant; determining the difference between the derived potential difference at the earlier point in time and the potential difference when no current is forced across the load; and combining the difference between the two potential differences with the known forced current (320) to determine the unknown series resistance (160).

2. A method as claimed in claim 1 wherein the rate of increase of the known current (320) forced through the circuit (200) is chosen so as to critically damp or over damp the effects of intrinsic reactance (221, 222) of the circuit on the potential difference (302) across the load (300).

3. A method as claimed in claim 1 or 2 wherein the earlier point in time is chosen so that, at that time, any effects arising from the intrinsic reactance (221, 222) of the circuit (200) on the potential difference across the load (300) have stabilised.

4. A method as claimed in any preceding claim wherein the time constant of the capacitor (211) is significantly larger than that of the intrinsic reactance (221, 222) of the circuit (200), and wherein the capacitance of the capacitor (211) is chosen so that the fractional drop in potential across the capacitor (211) during the time taken to determine the drop in the potential difference (302) across the load (300) is small, and the serial resistance of the capacitor (211) is low in comparison with the unknown resistance (160) it is desired to measure.

5. A method as claimed in any preceding claim wherein the circuit (200) comprises a fire alarm circuit, the load (300) includes an end of line load (310) for said fire alarm circuit (200) and the capacitor (211) is comprised in a control panel (110) for said fire alarm circuit (200).

6. A method as claimed in claim 5 wherein, the known substantially constant current (320) is greater than a current supplied by a power supply (110) of unknown impedance that flows through the end of line load (310) before said current (320) is forced through the circuit (200), and the load (300) comprises an active device.

7. A method as claimed in claim 5, 6 or 7, wherein the step of measuring the potential difference (302) across the load (300) when no known current is being forced comprises the step of disconnecting the end of line load (310) and measuring the potential difference (302) to determine the potential difference across the load (300) when no current is flowing.

8. A method as claimed in any anyone of claims 5 to 7, further comprising the step of comparing the measured unknown resistance (160) with a threshold resistance, wherein, in the event that the measured resistance (160) exceeds the threshold resistance, the method further comprises the step of sending a signal indicative of this, the signal only being sent if the measured resistance (160) exceeds the threshold resistance for a plurality of successive measurements, the signal being sent by disconnecting the end of line load (310) from the circuit (200).

9. A method as claimed in any preceding claim wherein the unknown resistance (160) is measured periodically, and the time taken for each measurement is significantly shorter than the time between successive measurements.

10. An active device (300) suitable for acting as an end of line load (310) for a fire alarm circuit (200), said active device (300) comprising: two terminals (301a, 301b) to which a fire alarm circuit (200) may be connected; a load impedance (310) connected between the terminals (301a, 301b); a processing means (350) for monitoring the potential difference across the two terminals (301a, .301b); a means (320) for forcing a known constant current through a fire alarm circuit (200) connected to the two terminals (301a, 301b); the processing means (350) being arranged to measure the potential difference across the two terminals (301a, 301b) whilst a known constant current (320) is being forced through a circuit (200) connected to the terminals (301a, 301b) at two points in time and deriving from those measurements, by extrapolation, a potential difference across the terminals (301a, 301b) at an earlier time whilst a current was being forced across the terminals (301a, 301b), wherein the means (320) for forcing a known substantially constant current (320) through a circuit (200) is operable to increase the value of the current that is forced through the circuit (200) from zero up to the substantially constant current (320), and wherein the processing means (350) is further arranged to measure the potential difference between the terminals (301a, 301b) when no current is being forced between the terminals (301a, 301b), and to calculate the difference between this potential difference and that derived by extrapolation to calculate a series resistance (160) in a fire alarm circuit (200) connected to the device (300) using the calculated difference in potential differences and the value of the known constant current.

11. An active device as claimed in claim 10 further comprising a means (311) for controlling the load impedance (310).

12. An active device as claimed in either claim 10 or 11 wherein the means (320) for forcing a known current through a circuit (200) to which the two terminals (301a, 301b) are connected comprises a current source (320) connected across the two terminals (301a, 301b) of the active device (300) and in parallel with the load impedance (310); wherein the load impedance (310) and means (320) for forcing a known current are implemented by the same component or components.

13. An active device as claimed in any one of claims 10 to 12 wherein the active device (300) is arranged to draw its operating power from a circuit (340) connected to the two terminals (301a, 301b).

14. A fire alarm system comprising a circuit (200) connected to an active device (300) as claimed in any of claims 10 to 13; wherein the opposite end of the circuit (200) to that connected to the active device (300) is connected to two terminals of a D.C. power supply (110) of unknown impedance and a capacitor (211) is connected across the terminals of said D. C. power supply (110); the serial resistance of the capacitor (211) being lower than the impedance of the said D. C. power supply (110).

15. A fire alarm system as claimed in claim 14 wherein the active device (300) is arranged to calculate a series resistance (160) in the circuit (200) by implementing a method as claimed in any of claims 1 to 9.

## Patentansprüche

1. Verfahren zur Messung eines unbekannten Widerstands (160) in einer Schaltung (200), wobei der Widerstand (160) mit einer Last (300) in Reihe geschaltet ist, umfassend die folgenden Schritte: Verbinden der Schaltung (200) mit einem Kondensator (211), wobei der Kondensator (211) parallel zu Ausgangsanschlussklemmen (113a, 113b) einer Gleichstromversorgung (110) mit unbekannter Ausgangsimpedanz geschaltet ist, und der Kondensator (211) einen Reihenwiderstand aufweist, der wesentlich niedriger als die Ausgangsimpedanz der Stromversorgung (110) und der unbekannte Reihenwiderstand (160) ist; Messen des Potenzialunterschieds (302) über die Last (300); Zwingen eines bekannten konstanten Stroms (320) durch die Schaltung (200), wobei der erzwungene Strom (320) von Null auf den im Wesentlichen konstanten bekannten Strom (320) erhöht wird, und ferner umfassend die Schritte: Während der bekannte konstante Strom (320) erzwungen wird, Messen des Potenzialunterschieds über die Last (300) an zwei Zeitpunkten, an welchen der erzwungene bekannte Strom (320) im Wesentlichen konstant ist, wobei die Potenzialunterschiede (302), die an den zwei Zeitpunkten gemessen werden, verwendet werden, um durch Extrapolieren den Potenzialunterschied über die Last (300) zu einem früheren Zeitpunkt zwischen der Zeit, wenn ein Strom (320) beginnt, über die Last gezwungen zu werden, und der Zeit, wenn der erzwungene bekannte Strom (320) im Wesentlichen konstant wird, abzuleiten; Bestimmen der Differenz zwischen dem abgeleiteten Potenzialunterschied an dem früheren Zeitpunkt und dem Potenzialunterschied, wenn kein Strom über die Last gezwungen wird; und Kombinieren der Differenz zwischen den zwei Potenzialunterschieden mit dem bekannten erzwungenen Strom (320), um den unbekannten Reihenwiderstand (160) zu bestimmen.

2. Verfahren nach Anspruch 1, wobei die Rate der Erhöhung des bekannten Stroms (320), der durch die Schaltung (200) gezwungen wird, so ausgewählt wird, dass die Wirkung des intrinsischen Blindwiderstands (221, 222) der Schaltung auf den Potenzialunterschied (302) über die Last (300) kritisch gedämpft oder überkritisch gedämpft wird.

3. Verfahren nach Anspruch 1 oder 2, wobei der frühere Zeitpunkt so ausgewählt wird, dass sich zu dieser Zeit jegliche Effekte auf den Potenzialunterschied über die Last (300), die sich aus dem intrinsischen Blindwiderstand (221, 222) der Schaltung (200) ergeben, stabilisiert haben.

4. Verfahren nach einem der vorhergehenden Ansprüche, wobei die Zeitkonstante des Kondensators (211) wesentlich größer ist als jene des intrinsischen Blindwiderstands (221, 222) der Schaltung (200), und wobei die Kapazität des Kondensators (211) so ausgewählt wird, dass der anteilige Potenzialabfall über den Kondensator (211) während der Zeit, die benötigt wird, um den Abfall in dem Potenzialunterschied (302) über die Last (300) zu bestimmen, klein ist, und der Reihenwiderstand des Kondensators (211) im Vergleich zu dem unbekannten Widerstand (160), der gemessen werden soll, gering ist.

5. Verfahren nach einem der vorhergehenden Ansprüche, wobei die Schaltung (200) eine Feuermeldeschaltung umfasst, wobei die Last (300) eine terminale Last (310) für die Feuermeldeschaltung (200) umfasst und der Kondensator (211) in einer Steuertafel (110) für die Feuermeldeschaltung (200) enthalten ist.

6. Verfahren nach Anspruch 5, wobei der bekannte, im Wesentlichen konstante Strom (320) größer als ein Strom ist, der durch eine Stromversorgung (110) mit unbekannter Impedanz geliefert wird und durch die terminale Last (310) strömt, bevor der Strom (320) durch die Schaltung (200) gezwungen wird, und wobei die Last (300) eine aktive Vorrichtung umfasst.

7. Verfahren nach Anspruch 5, 6 oder 7, wobei der Schritt des Messens des Potenzialunterschieds (302) über die Last (300), wenn kein bekannter Strom erzwungen wird, den Schritt des Trennens der terminalen Last (310) und des Messens des Potenzialunterschieds (302) umfasst, um den Potenzialunterschied über die Last (300) zu bestimmen, wenn kein Strom fließt.

8. Verfahren nach einem der Ansprüche 5 bis 7, ferner umfassend den Schritt des Vergleichens des gemessenen unbekannten Widerstands (160) mit einem Schwellenwiderstand, wobei, falls der gemessene Widerstand (160) den Schwellenwiderstand übersteigt, das Verfahren ferner den Schritt des Sendens eines Signals umfasst, das darauf hinweist, wobei dieses Signal nur gesendet wird, wenn der gemessene Widerstand (160) den Schwellenwiderstand für eine Vielzahl von aufeinander folgenden Messungen übersteigt, wobei das Signal gesendet wird, indem die terminale Last (310) von der Schaltung (200) getrennt wird.

9. Verfahren nach einem der vorhergehenden Ansprüche, wobei der unbekannte Widerstand (160) periodisch gemessen wird, und die Zeit, die für jede Messung benötigt wird, wesentlich kürzer als die Zeit zwischen aufeinander folgenden Messungen ist.

10. Aktive Vorrichtung (300), die dazu geeignet ist, als terminale Last (310) für eine Feuermeldeschaltung (200) zu dienen, wobei die aktive Vorrichtung (300) umfasst: zwei Anschlussklemmen (301a, 301b), mit welchen eine Feuermeldeschaltung (200) verbunden werden kann; eine Lastimpedanz (310), die zwischen die Anschlussklemmen (301a, 301b) geschaltet ist; ein Verarbeitungsmittel (350) zur Überwachung des Potenzialunterschieds über die zwei Anschlussklemmen (301a, 301b); ein Mittel (320) zum Zwingen eines bekannten konstanten Stroms durch eine Feuermeldeschaltung (200), die mit den zwei Anschlussklemmen (301a, 301b) verbunden ist; wobei das Verarbeitungsmittel (350) angeordnet ist, um den Potenzialunterschied über die zwei Anschlussklemmen (301a, 301b) an zwei Zeitpunkten zu messen, während ein bekannter konstanter Strom (320) durch eine Schaltung (200) gezwungen wird, die mit den Anschlussklemmen (301a, 301b) verbunden ist, und um aus diesen Messungen durch Extrapolieren einen Potenzialunterschied über die Anschlussklemmen (301a, 301b) zu einer früheren Zeit abzuleiten, während der ein Strom über die Anschlussklemmen (301a, 301b) gezwungen wurde, wobei das Mittel (320) zum Zwingen eines bekannten, im Wesentlichen konstanten Stroms (320) durch eine Schaltung (200) betätigbar ist, um den Wert des Stroms, der durch die Schaltung (200) gezwungen wird, von Null bis auf den im Wesentlichen konstanten Strom (320) zu erhöhen, und wobei das Verarbeitungsmittel (350) ferner angeordnet ist, um den Potenzialunterschied zwischen den Anschlussklemmen (301a, 301b) zu messen, wenn kein Strom über die Anschlussklemmen (301a, 301b) gezwungen wird, und um die Differenz zwischen diesem Potenzialunterschied und jenem, der durch Extrapolieren abgeleitet wurde, zu berechnen, um einen Reihenwiderstand (160) in einer Feuermeldeschaltung (200) zu berechnen, die mit der Vorrichtung (300) verbunden ist, unter Verwendung der berechneten Differenz in den Potenzialunterschieden und des Werts des bekannten konstanten Stroms.

11. Aktive Vorrichtung nach Anspruch 10, ferner umfassend ein Mittel (311) zur Steuerung der Lastimpedanz (310).

12. Aktive Vorrichtung nach Anspruch 10 oder 11, wobei das Mittel (320) zum Zwingen eines bekannten Stroms durch eine Schaltung (200), mit welcher die zwei Anschlussklemmen (301a, 301b) verbunden sind, eine Stromquelle (320) umfasst, die über die zwei Anschlussklemmen (301a, 301b) der aktiven Vorrichtung (300) und parallel zu der Lastimpedanz (310) verbunden ist; wobei die Lastimpedanz (310) und das Mittel (320) zum Zwingen eines bekannten Stroms durch dieselbe Komponente oder dieselben Komponenten implementiert sind.

13. Aktive Vorrichtung nach einem der Ansprüche 10 bis 12, wobei die aktive Vorrichtung (300) angeordnet ist, um ihre Betriebsleistung aus einer Schaltung (340) zu beziehen, die mit den zwei Anschlussklemmen (301a, 301b) verbunden ist.

14. Feuermeldesystem umfassend eine Schaltung (200), die mit einer aktiven Vorrichtung (300) nach einem der Ansprüche 10 bis 13 verbunden ist; wobei das Ende der Schaltung (200), das jenem gegenüberliegt, das mit der aktiven Vorrichtung (300) verbunden ist, mit zwei Anschlussklemmen einer Gleichstromversorgung (110) mit unbekannter Impedanz verbunden ist, und ein Kondensator (211) über die Anschlussklemmen der Gleichstromversorgung (110) verbunden ist; wobei der Reihenwiderstand des Kondensators (211) niedriger als die Impedanz der Gleichstromversorgung (110) ist.

15. Feuermeldesystem nach Anspruch 14, wobei die aktive Vorrichtung (300) angeordnet ist, um einen Reihenwiderstand (160) in der Schaltung (200) durch Implementieren eines Verfahrens nach einem der Ansprüche 1 bis 9 zu berechnen.

## Revendications

1. Procédé de mesure d'une résistance (160) inconnue d'un circuit (200), la résistance (160) étant montée en série avec une charge (300), le procédé comprenant les stades de :
connecter le circuit (200) à un condensateur (211), le condensateur (211) étant connecté en parallèle à des bornes (113a, 113b) de sortie d'une alimentation (110) en courant continu d'une impédance de sortie inconnue et le condensateur (211) a une résistance série, qui est sensiblement plus petite que l'impédance de sortie de l'alimentation (110) en courant et de la résistance (160) série inconnue; mesurer la différence (302) de potentiel aux bornes de la charge (300); forcer un courant (320) constant connu dans le circuit (200), le courant (320) forcé étant augmenté de zéro au courant (320) connu sensiblement constant, et comprenant, en outre, les stades dans lesquels, alors que l'on force le courant (320) constant connu, on mesure la différence de potentiel aux bornes de la charge (300) en deux points dans le temps, où le courant (320) forcé est sensiblement constant, et on utilise les différences (302) de potentiel mesurées aux deux points dans le temps pour en déduire, par extrapolation, la différence de potentiel aux bornes de la charge (300) à un point antérieur dans le temps entre l'instant où un courant (320) commence à être forcé dans la charge et l'instant où le courant (320) connu forcé devient sensiblement constant; on détermine la différence entre la différence de potentiel déduite au point antérieur dans le temps et la différence de potentiel lorsque du courant n'est pas forcé dans la charge et on combine la différence entre les deux différences de potentiel au courant (320) forcé connu pour déterminer la résistance (160) série inconnue.

2. Procédé suivant la revendication 1, dans lequel on choisit la vitesse d'augmentation du courant (320) connu forcé dans le circuit (200), de manière à amortir, d'une manière critique, ou à suramortir les effets d'une réactance (221, 222) intrinsèque du circuit sur la différence (302) de potentiel aux bornes de la charge (300).

3. Procédé suivant la revendication 1 ou 2, dans lequel le point antérieur dans le temps est choisi de manière à ce qu'à cet instant, tout effet provenant de la réactance (221, 222) intrinsèque du circuit (200) sur la différence de potentiel aux bornes de la charge (300) ait été stabilisé.

4. Procédé suivant l'une quelconque des revendications précédentes, dans lequel la constante de temps du condensateur (211) est significativement plus grande que celle de la réactance (221, 222) intrinsèque du circuit (200) et dans lequel la capacité du condensateur (211) est choisie de manière à ce que la chute fractionnelle de potentiel aux bornes du condensateur (211), pendant le temps pris pour déterminer la chute de la différence (302) de potentiel aux bornes de la charge (300), soit petite et la résistance série du condensateur (211) est petite par rapport à la résistance (160) inconnue que l'on souhaite mesurer.

5. Procédé suivant l'une quelconque des revendications précédentes, dans lequel le circuit (200) comprend un circuit d'alerte d'incendie, la charge (300) comprenant une extrémité de charge (310) de ligne du circuit (200) d'alerte d'incendie et le condensateur (211) est compris dans un panneau (110) de commande du circuit (200) d'alerte d'incendie.

6. Procédé suivant la revendication 5, dans lequel le courant (320) connu sensiblement constant est plus grand qu'un courant fourni par une alimentation (110) en courant d'impédance inconnue, qui passe dans l'extrémité de la charge (310) de ligne avant que le courant (320) soit forcé dans le circuit (200), et la charge (300) comprend un dispositif actif.

7. Procédé suivant la revendication 5, 6 ou 7, dans lequel le stade de mesure de la différence (302) de potentiel aux bornes de la charge (300) lorsque du courant connu n'est pas forcé, comprend le stade de déconnecter l'extrémité de la charge (310) de ligne et de mesurer la différence (302) de potentiel pour déterminer la différence de potentiel aux bornes de la charge (300) lorsqu'il ne passe pas de courant.

8. Procédé suivant l'une quelconque des revendications 5 à 7, comprenant, en outre, le stade de comparaison de la résistance (160) inconnue mesurée à une résistance de seuil, dans lequel, dans le cas où la résistance (160) mesurée dépasse la résistance de seuil, le procédé comprend, en outre, le stade d'envoi d'un signal l'indiquant, le signal étant envoyé seulement si la résistance (160) mesurée dépasse la résistance de seuil pendant une pluralité de mesures successives, le signal étant envoyé en déconnectant l'extrémité de la charge (310) de ligne du circuit (200).

9. Procédé suivant l'une quelconque des revendications précédentes, dans lequel on mesure périodiquement la résistance (160) inconnue et le temps pris pour chaque mesure est significativement plus court que le temps entre des mesures successives.

10. Dispositif (300) actif propre à agir comme extrémité d'une charge (310) de ligne d'un circuit (200) d'alerte d'incendie, le dispositif (300) actif comprenant : deux bornes (301a, 301b), auxquelles un circuit (200) d'alerte d'incendie peut être connecté; une impédance (310) de charge, montée entre les bornes (301a, 301b); un moyen (350) de traitement pour contrôler la différence de potentiel entre les deux bornes (301a, 301b); un moyen (320) pour forcer un courant constant connu dans un circuit (200) d'alerte d'incendie connecté aux deux bornes (301a, 301b), le moyen (350) de traitement étant conçu pour mesurer la différence de potentiel entre les deux bornes (301a, 301b), alors qu'un courant (320) constant connu est forcé dans un circuit (200) connecté aux bornes (301a, 301b) en deux points dans le temps et en dérivant de ces mesures, par extrapolation, une différence de potentiel entre les bornes (301a, 301b) à un instant antérieur, alors qu'un courant était forcé entre les bornes (301, 301b), le moyen (320) pour forcer un courant (320) connu sensiblement constant dans un circuit (200) pouvant fonctionner pour augmenter la valeur du courant, qui est forcé dans le circuit (200) de zéro au courant (320) sensiblement constant, et dans lequel le moyen (350) de traitement est conçu, en outre, pour mesurer la différence de potentiel entre les bornes (301a, 301b), lorsque du courant n'est pas forcé entre les bornes (301a, 301b), et pour calculer la différence entre la différence de potentiel et celle déduite par extrapolation pour calculer une résistance (160) série du circuit (200) d'alerte d'incendie connecté au dispositif (300), en utilisant la différence calculée de différences de potentiel et la valeur du courant constant connu.

11. Dispositif actif suivant la revendication 10, comprenant, en outre, un moyen (311) de commande de l'impédance (310) de charge.

12. Dispositif actif suivant la revendication 10 ou 11, dans lequel le moyen (320), pour forcer un courant connu dans un circuit (200) auquel les deux bornes (301a, 301b) sont connectées, comprend une source (320) de courant montée entre les deux bornes (301a, 301b) du dispositif (300) actif et en parallèle avec l'impédance (310) de charge; l'impédance (310) de charge et le moyen (320) pour forcer un courant connu étant mis en oeuvre par le même composant ou les mêmes composants.

13. Dispositif actif suivant l'une quelconque des revendications 10 à 12, dans lequel le dispositif (300) actif est conçu pour tirer sa puissance de fonctionnement d'un circuit (340) connecté aux deux bornes (301a, 301b).

14. Système d'alerte d'incendie, comprenant un circuit (200) connecté à un dispositif (300) actif tel que revendiqué à l'une quelconque des revendications 10 à 13, dans lequel l'extrémité du circuit (200) opposée à celle connectée au dispositif (300) actif est connectée à deux bornes d'une alimentation (110) en courant continu d'impédance inconnue et un condensateur (211) est monté entre les bornes de l'alimentation (110) en courant continu; la résistance série du condensateur (211) étant plus petite que l'impédance de l'alimentation (110) en courant continu.

15. Système d'alerte d'incendie suivant la revendication 14, dans lequel le dispositif (300) actif est conçu pour calculer une résistance (160) série du circuit (200) en mettant en oeuvre un procédé tel que revendiqué à l'une quelconque des revendications 1 à 9.
